# DEMANDE DE BREVET EUROPEEN

(11) **EP 4 560 697 A1**
(43) Date de publication de la demande: **28.05.2025**
(21) Numéro de dépôt: 24211743.0
(22) Date de dépôt: 08.11.2024
(51) Int. Cl.: H01L 23/367, H01L 25/07

(54) **MODULE ÉLECTRONIQUE DE PUISSANCE À ÉLÉMENT DE RETARDEMENT THERMIQUE LORS D'UN COURT-CIRCUIT**

(30) Priorité: 22.11.2023 FR 2312899
(71) Demandeur: Safran Electrical & Power, 31702 Blagnac (FR)
(72) Inventeur: GUENOT, Stéphane, 77550 MOISSY CRAMAYEL (FR)
(74) Mandataire: Casalonga

(57) **Abrégé**

Module (10) électronique de puissance comprenant un substrat (11) comprenant au moins un circuit de puissance (11c), ledit module (10) comprenant au moins un joint principal d'interconnexion (13) solidaire du circuit de puissance (11c) et au moins un semi-conducteur (12) comprenant une surface supérieure (12b) métallisée et une surface inférieure (12a) assemblée au circuit de puissance (11c) par l'intermédiaire du joint principal d'interconnexion (13).

Le module comprend au moins un joint secondaire d'interconnexion (17) solidaire de la surface supérieure (12b) métallisée du semi-conducteur (12) et au moins une saillie (20) dotée d'une capacité de retardement thermique et solidaire de ladite surface supérieure (12b) métallisée par l'intermédiaire du joint secondaire (17) d'interconnexion.

## Description

### Domaine technique de l'invention

La présente invention concerne les modules dits de puissance, i.e. les modules utilisés dans le domaine de l'électronique de puissance.

L'invention trouve une application particulière dans le domaine de l'aéronautique.

Les modules d'électronique de puissance sont intégrés dans des convertisseurs nécessaires pour l'électrification des systèmes propulsifs et non propulsifs à bord des aéronefs. Ils permettent de convertir l'énergie électrique du réseau principal (115V AC, 230V AV, 540V DC, ...) sous plusieurs formes (AC/DC, DC/AC, AC/AC et DC/DC).

### Etat de la technique antérieure

De façon connue, un module de puissance comprend des semi-conducteurs pilotés par une électronique extérieure. De tels composants adoptent principalement deux états stationnaires (un état passant, permettant la conduction d'un courant ou un état bloqué, empêchant toute conduction de courant) ainsi qu'un état transitoire, par lequel le composant passe pour aller de l'état passant à l'état bloqué, ou inversement

Un défaut extérieur au module de puissance peut subvenir, augmentant significativement la valeur du courant vu par les semi-conducteurs en conduction, notamment sous l'effet de la puissance fournie par une source de tension extérieure.

On connaît le composant semi-conducteur dénommé MOSFET, acronyme de « metal-oxide-semiconductor field-effect transistor » en termes anglo-saxons.

Un tel semi-conducteur peut être réalisé en utilisant du Silicium, comme du carbure de silicium composé chimique de formule SiC.

L'augmentation de la valeur du courant va induire la mise en court-circuit du semi-conducteur, notamment dans le cas d'un MOSFET-SiC, après emballement thermique. Cet état de « court-circuit » n'est pas toujours désiré, car l'utilisateur n'a alors plus le contrôle sur la commande du semi-conducteur concerné.

Il est par conséquence impossible de commander le(s) semi-conducteur(s) à l'état ouvert.

Par ailleurs, l'énergie dissipée dans le module de puissance devient alors très importante et peut conduire à la destruction de tout ou partie du module électronique de puissance. La panne du module électronique de puissance entraine la perte de la disponibilité de l'équipement et contraint toute la chaîne électrique en amont comme en aval.

Les modules de puissance conçus actuellement sont avant tout définis pour répondre à des besoins tels que : un encombrement maximum, une nature de montage et la tenue d'exigences fonctionnelles, de performances, environnementales, d'efficacité ou encore de durée de vie et/ou fiabilité. Ils n'ont en revanche pas toujours pour objectif de répondre à une exigence visant l'obtention d'un mode de panne du type circuit ouvert, dans les cas de défaut précités.

L'amélioration des modules de puissance connus est une nécessité.

### Exposé de l'invention

La présente invention a donc pour but de palier les inconvénients précités.

Le but de l'invention est donc d'éviter la dégradation des semi-conducteurs d'un module de puissance en cas de surchauffe liée à un court-circuit.

Plus particulièrement, la présente invention a pour objectif de répondre à une exigence visant à obtenir un mode de panne du type circuit ouvert, dans les cas de défauts décrits ci-dessus.

L'invention a pour objet un module électronique de puissance comprenant un substrat comprenant au moins un circuit de puissance, ledit module comprenant au moins un joint principal d'interconnexion solidaire du circuit de puissance et au moins un composant à semi-conducteur ou semi-conducteur s'étendant selon un plan d'extension, par exemple horizontal, et comprenant une surface supérieure métallisée et une surface inférieure assemblée au circuit de puissance par l'intermédiaire du joint principal d'interconnexion.

Le module électronique de puissance comprend au moins un joint secondaire d'interconnexion solidaire de la surface supérieure métallisée du semi-conducteur et au moins un élément ou une saillie dotée d'une capacité de retardement thermique et solidaire de ladite surface supérieure métallisée par l'intermédiaire du joint secondaire d'interconnexion.

L'extrémité de la saillie non solidaire de ladite surface supérieure métallisée est toujours laissée libre. En d'autres termes, la saillie est uniquement raccordée à la surface supérieure métallisée.

Ceci permet un montage simplifié de la saillie.

Il est intéressant pour un utilisateur de pouvoir disposer d'un module électronique de puissance qui, soumis à des conditions de court-circuit, du fait d'un défaut interne et/ou externe, est en mesure d'adopter un circuit ouvert, sans être assujetti à une dégradation violente, comme une explosion par exemple.

La connexion thermique entre la saillie de retardement thermique et le semi-conducteur via le joint de connexion supplémentaire permet de limiter l'augmentation de la température de la surface extérieure du semi-conducteur. En procédant ainsi, on bénéficie d'un mode de panne en circuit-ouvert du semi-conducteur.

La saillie de retardement thermique est un élément additionnel à une connexion électrique, pouvant être du type « wire bonding ».

Il est préférable que la surface de contact entre la saillie de retardement thermique et la surface supérieure métallisée du semi-conducteur soit maximale, avec la contrainte que cette surface de contact sera limitée par la surface occupée par les connexions électriques telles que, par exemple, les connexions du type wire bonding.

La saillie de retardement thermique permet d'apporter de l'inertie thermique sur la surface extérieure métallisée, appelée métallisation, du semi-conducteur qui est très contrainte lors d'un mode de fonctionnement du semi-conducteur en circuit ouvert, ce qui permet d'éviter une dégradation dudit semi-conducteur.

En effet, dans le cas d'un court-circuit, le courant traversant le semi-conducteur est plus important que le courant pour lequel ledit semi-conducteur est conçu. La température des zones du semi-conducteur faisant transiter le courant principal augmente de façon importante, et ce malgré la courte durée du court-circuit. Généralement, il s'agit de la zone de métallisation de surface, c'est-à-dire la surface supérieure métallisée du semi-conducteur, mal reliée thermiquement au substrat, qui est une source froide.

Sous l'effort d'une importante quantité d'énergie concentrée au niveau de la zone de métallisation de surface du semi-conducteur, la métallisation peut changer d'état et passer d'un état solide à un état liquide, puis gazeux pour une partie des constituants de la métallisation et enfin à nouveau à un état solide présentant des aspérités de surface.

La dynamique de cette transformation est directement liée à la vitesse de montée en température de la métallisation. Elle dépend donc de l'énergie à dissiper mais également de la nature des échanges thermiques entre la métallisation et son milieu. Plus la dynamique de transformation est importante et plus le risque d'obtention d'un semi-conducteur dans un état de court-circuit non contrôlable est élevé. En revanche, plus la dynamique est faible, moins ce risque est élevé et on peut obtenir un semi-conducteur forcé dans un état ouvert, sans subir une dégradation incontrôlable.

La saillie de retardement thermique permet d'établir un contact thermique performant avec la métallisation du semi-conducteur jouant le rôle de retardateur thermique. La capacité de la saillie de retardement thermique à jouer ce rôle de retardateur thermique est déterminée par la performance en conduction thermique ainsi que le surplus d'inertie thermique apportée par l'assemblage du semi-conducteur avec la saillie de retardement thermique.

La réalisation d'un tel assemblage permet de forcer le passage du semi-conducteur de l'état de court-circuit à l'état de circuit ouvert, assurant l'obtention d'un dégradation « propre » au sein du module électronique de puissance, c'est-à-dire n'endommageant pas d'autres composants du module électronique de puissance.

Par exemple, la saillie de retardement thermique s'étend dans une direction perpendiculaire au plan d'extension du semi-conducteur.

Par exemple, la saillie de retardement thermique présente une forme de cylindre.

En variante, on pourrait prévoir toute autre forme pour ladite saillie de retardement thermique par exemple semi-sphérique, cylindrique creux, parallélépipédique.

On pourrait également prévoir que la saillie de retardement thermique soit sous la forme d'un feuillard métallique.

La saillie de retardement thermique est, par exemple, réalisée en matériau conducteur, par exemple métallique, par exemple en cuivre.

Selon un mode de réalisation, le module électronique de puissance comprend une pluralité de saillies de retardement thermique réparties sur la surface supérieure métallisée du semi-conducteur.

Le semi-conducteur peut comprendre un drain disposé sur la face inférieure et une grille et une source disposées sur la face supérieure, le semi-conducteur comprenant en outre une métallisation du drain, de la grille et de la source.

Par exemple, les saillies de retardement thermique sont réparties autour de la source du semi-conducteur.

Par exemple, le drain du semi-conducteur est relié au substrat par un joint principal d'interconnexion ou brasure et dispose ainsi d'une bonne connexion thermique avec le substrat.

Par exemple, la source du semi-conducteur est reliée au substrat par les fils de câblage, par exemple par une technique de procédé de soudage qui permet de faire une liaison filaire, ou « wire bonding » en termes anglo-saxons, assurant une connexion électrique entre la source du semi-conducteur et le substrat. Cette connexion ne permet pas toujours de disposer d'une bonne connexion thermique.

Selon un mode de réalisation, le joint principal d'interconnexion est sous la forme d'une pâte, par exemple une brasure, et le joint secondaire d'interconnexion est sous la forme d'une pâte, par exemple une brasure, la pâte formant le joint principal d'interconnexion présente un liquidus supérieur au liquidus de la pâte formant joint secondaire d'interconnexion. Ceci permet que les semi-conducteurs restent en position lors de l'étape d'assemblage des saillies de retardement thermique.

Par exemple, le joint principal d'interconnexion est relié au substrat, notamment à la couche supérieure conductrice, par brasage.

A titre d'exemple nullement limitatif, le substrat comprend successivement une couche inférieure conductrice, une couche électriquement isolante et une couche supérieure conductrice.

La couche inférieure et la couche supérieure conductrices sont, par exemple réalisées en matériau métallique.

La couche électriquement isolante est, par exemple, réalisée en matériau céramique.

Par exemple, ladite couche électriquement isolante est agencée entre la couche inférieure et la couche supérieure conductrices.

La couche inférieure et la couche supérieure conductrices peuvent être assemblées à la couche électriquement isolante par une des différentes techniques connues, comme par exemple par brasage, ou « active métal brazing », d'acronyme AMB en termes anglo-saxons, ou encore par liaison direct de cuivre ou « direct bonded copper », d'acronyme DBD en termes anglo-saxons ou encore par liaison direct d'aluminium ou « direct bonded aluminium », d'acronyme DBA en termes anglo-saxons.

En variante, on pourrait prévoir d'autres couches formant le substrat.

La couche supérieure conductrice forme un circuit de puissance sur lequel des composants à semi-conducteur de puissance sont assemblés.

Par exemple, le module électronique de puissance peut comprendre en outre des connectiques permettant de raccorder le module électronique de puissance à des éléments électriques extérieurs.

Selon un mode de réalisation, le module électronique de puissance comprend en outre au moins une connectique solidaire du circuit de puissance et au moins un fils de câblage reliant électriquement la connectique et le semi-conducteur, notamment la source du semi-conducteur.

Par exemple, et de manière nullement limitative, le module électronique de puissance comprend un boitier, par exemple en matière plastique tel que du polymère entourant les composants à semi-conducteur et solidaire du substrat, notamment par collage à l'aide d'un adhésif.

Par exemple, le boitier peut être rempli par un encapsulant, par exemple un gel ou une résine époxy pour assurer une protection mécanique et électrique des composants de puissance et des fils de câblage.

Par exemple, le semi-conducteur est puce électronique connue sous le nom de MOSFET, acronyme de « metal-oxide-semiconductor field-effect transistor » en termes anglo-saxons et peut comprendre un carbure de silicium, composé chimique de formule SiC.

En variante, on pourrait prévoir que les semi-conducteurs comprennent d'autres matériaux.

Selon un second aspect, l'invention concerne un procédé de fabrication d'un module électronique de puissance comprenant un substrat comprenant au moins un circuit de puissance, dans lequel :
- on prépare le substrat ;
- on dépose au moins un joint principal d'interconnexion ou brasure sur le circuit de puissance du substrat ; et
- on assemble au moins un semi-conducteur au circuit de puissance du substrat par l'intermédiaire du joint principal d'interconnexion par exemple par des techniques de brasage ou frittage.

Selon le procédé :
- on dépose au moins un joint secondaire d'interconnexion ou brasure sur une surface supérieure métallisée du semi-conducteur ; et
- on assemble au moins une saillie de retardement thermique sur ladite surface supérieure métallisée par l'intermédiaire du joint secondaire d'interconnexion.

Par exemple, la saillie de retardement thermique s'étend dans une direction perpendiculaire au plan d'extension du semi-conducteur.

Par exemple, le procédé comprend en outre une étape de raccordement électrique du semi-conducteur, et notamment de la source, par des fils de câblage, par exemple par une technique de procédé de soudage qui permet de faire une liaison filaire, ou « wire bonding » en termes anglo-saxons. Ceci permet d'assurer une connexion électrique entre la source du semi-conducteur et le substrat.

De manière nullement limitative, le procédé pourrait également prévoir des étapes ultérieures, d'assemblage du capot, d'injection d'un encapsulant, etc...

### Brève description des dessins

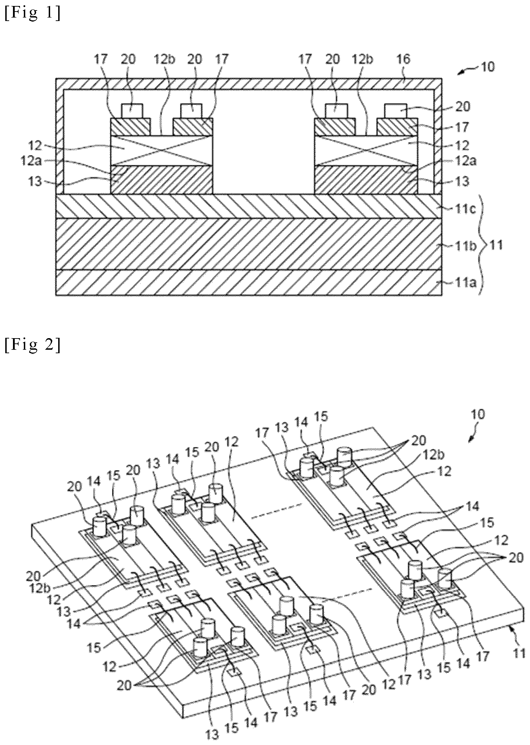

D'autres buts, caractéristiques et avantages de l'invention apparaîtront à la lecture de la description suivante, donnée uniquement à titre d'exemple non limitatif, et faite en référence aux dessins indexés sur lesquels :
[Fig 1],
   est une vue schématique en coupe d'un module électronique de puissance selon l'invention ;
[Fig 2],
   est une vue en perspective du module électronique de puissance de la figure 1 ;
[Fig 3]
   illustre les étapes d'un organigramme d'un procédé de fabrication du module électronique de puissance de la figure 1 ; et

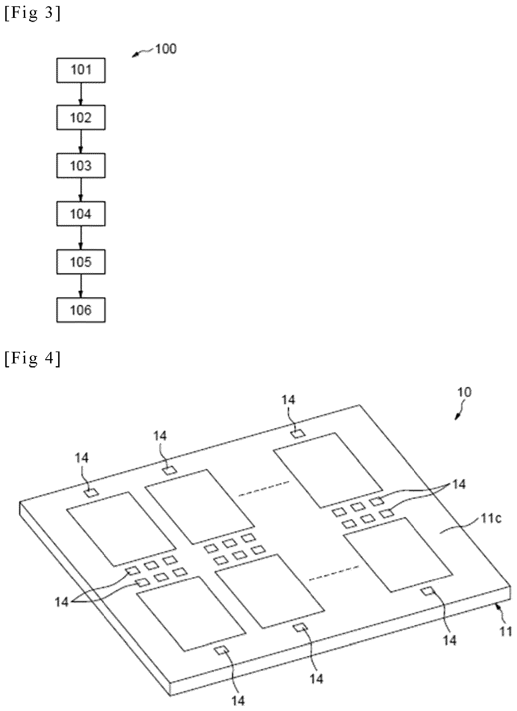

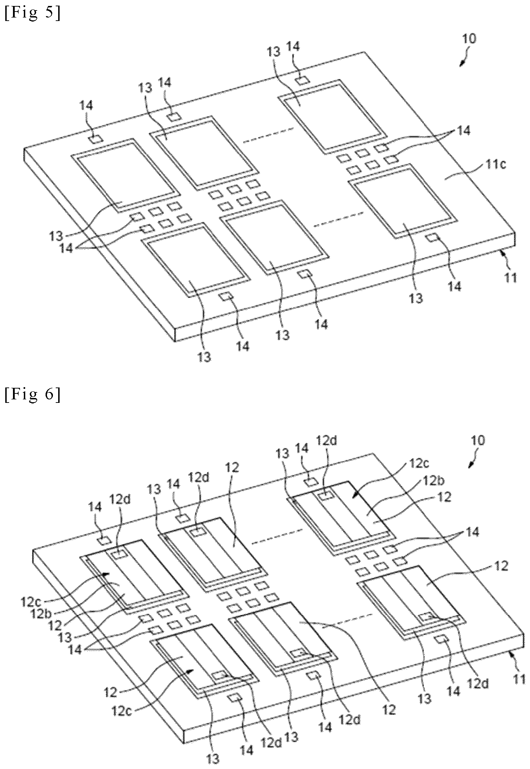

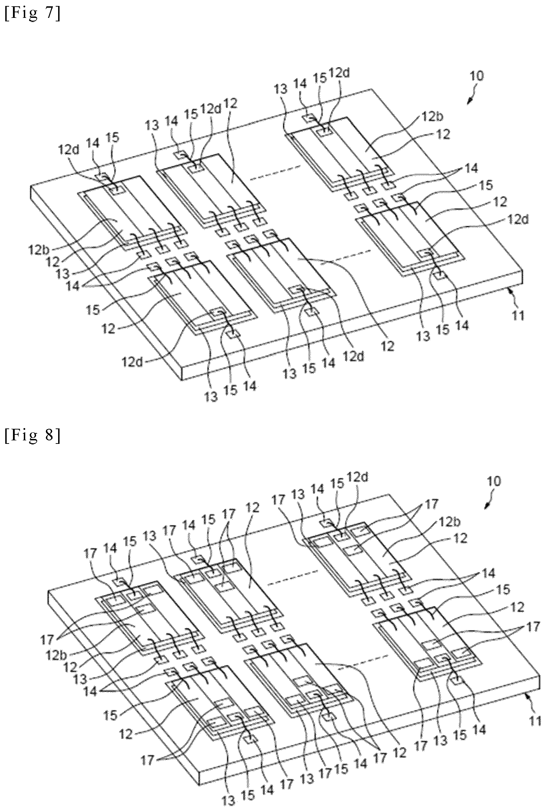

[Fig.4], [Fig.5], [Fig.6], [Fig.7] et [Fig.8]
   représentent le module électronique de puissance de la figure 1 lors des différentes étapes du procédé de fabrication de la figure 3, le module a été représenté ici sans capot.

### Exposé détaillé d'au moins un mode de réalisation

Tel qu'illustré sur la figure 1, un module électronique de puissance 10 comprend un substrat 11.

A titre d'exemple nullement limitatif, le substrat 11 comprend successivement une couche inférieure conductrice 11a, une couche intermédiaire électriquement isolante 11b et une couche supérieure conductrice 11c.

La couche inférieure et la couche supérieure conductrices Il a, 11c sont, par exemple réalisées en matériau métallique.

La couche intermédiaire 11b électriquement isolante est, par exemple, réalisée en matériau céramique.

Ladite couche intermédiaire électriquement isolante 11b est agencée entre la couche inférieure 11a et la couche supérieure 11c conductrices.

La couche inférieure 11a et la couche supérieure 11c conductrices sont assemblées à la couche intermédiaire électriquement isolante 11b par une des différentes techniques connues, comme par exemple par brasage, ou « active métal brazing », d'acronyme AMB en termes anglo-saxons, ou encore par liaison direct de cuivre ou « direct bonded copper », d'acronyme DBD en termes anglo-saxons ou encore par liaison direct d'aluminium ou « direct bonded aluminium », d'acronyme DBA en termes anglo-saxons.

En variante, on pourrait prévoir d'autres couches formant le substrat 11.

La couche supérieure 11c conductrice forme un circuit de puissance sur lequel des composants à semi-conducteur de puissance 12 sont assemblés. Ici, un nombre de six semi-conducteurs 12 sont assemblés sur la couche supérieure 11c conductrice. En variante, on pourrait prévoir un nombre de semi-conducteur supérieur ou égal à un.

Tel qu'illustré, le module électronique de puissance 10 comprend en outre des joints principaux d'interconnexion 13 par l'intermédiaire desquels les composants à semi-conducteur 12 sont assemblés au circuit de puissance 11c.

Les joints principaux d'interconnexion 13 peuvent être sous la forme d'une pâte, par exemple une brasure ou de préforme de brasure.

Les joints principaux d'interconnexion 13 peuvent être reliés au substrat 11, notamment à la couche supérieure 11c conductrice, par brasage.

L'assemblage des joints principaux d'interconnexion 13 avec le substrat 11 est connu et ne sera pas davantage décrit.

Le module électronique de puissance 10 peut comprendre en outre des connectiques (non représentées) permettant de raccorder le module électronique de puissance 10 à des éléments électriques extérieurs (non représentés).

Tel qu'illustré, et de manière nullement limitative, le module électronique de puissance 10 comprend en outre des connectiques 14 et des connections électriques 15, par exemple sous la forme de fils de câblage, reliant électriquement les connectiques 14 et les semi-conducteurs 12.

Tel qu'illustré sur la figure 1, et de manière nullement limitative, le module électronique de puissance 10 comprend un boitier 16, par exemple en matière plastique tel que du polymère entourant les composants à semi-conducteur 12 et solidaire du substrat 11, notamment par collage à l'aide d'un adhésif (non représenté).

Le boitier 16 peut être rempli par un encapsulant, par exemple un gel ou une résine époxy pour assurer une protection mécanique et électrique des composants de puissance 12, 14 et des fils de câblage 15.

Les semi-conducteurs 12 comprennent par exemple une puce électronique connue sous le nom de MOSFET, acronyme de « metal-oxide-semiconductor field-effect transistor » en termes anglo-saxons et peut comprendre un carbure de silicium, composé chimique de formule SiC.

En variante, on pourrait prévoir que les semi-conducteurs 12 comprennent d'autres matériaux.

De manière générale, chaque semi-conducteur 12 s'étend selon un plan horizontal et comprend une face inférieure 12a, côté substrat 11, et une face supérieure 12b métallisée.

Par « face supérieure métallisée », on entend que la face ou surface supérieure 12b du semi-conducteur 12 est dotée d'une métallisation de surface.

Chaque semi-conducteur 12 comprend un drain (non visible sur les figures) disposé sur la face inférieure 12a et une grille 12c et une source 12d disposées sur la face supérieure 12b métallisée. Chaque semi-conducteur 12 dispose d'une métallisation de drain, de la grille 12c et de la source 12d.

Le drain du semi-conducteur 12 est relié au substrat 11 par un joint principal d'interconnexion 13 ou brasure et dispose ainsi d'une bonne connexion thermique avec le substrat 11.

La source du semi-conducteur 12 est reliée au substrat 11 par les fils de câblage 15, par exemple par une technique de procédé de soudage qui permet de faire une liaison filaire, ou « wire bonding » en termes anglo-saxons, assurant une connexion électrique entre la source du semi-conducteur 12 et le substrat 11, mais ne permet pas, via cette connexion, de disposer d'une bonne connexion thermique.

Tel qu'illustré, le module électronique de puissance 10 comprend en outre une pluralité de saillies 20 dotées chacune d'une capacité de retardement thermique et solidaires de chaque semi-conducteur 12 à l'aide d'un joint secondaire d'interconnexion 17.

Chaque saillie 20 dotée d'une capacité de retardement thermique est nommée saillie de retardement thermique.

En d'autres termes, les saillies 20 dites de retardement thermique sont assemblées sur la surface supérieure 12b métallisée des semi-conducteurs 12 via les joints secondaires 17 d'interconnexion.

Les joints secondaires d'interconnexion 17 peuvent être sous la forme d'une pâte, par exemple une brasure.

La pâte formant les joints principaux 13 d'interconnexion présente un liquidus supérieur au liquidus de la pâte formant les joints secondaires 17 d'interconnexion afin que les semi-conducteurs 12 ne bougent pas lors de l'étape d'assemblage des saillies de retardement thermique.

Dans un diagramme de phases, la courbe qui sépare un domaine monophasé liquide d'un domaine biphasé comprend un liquide et une solution solide.

Les saillies 20 de retardement thermique s'étendent, ici, dans une direction perpendiculaire au plan d'extension des semi-conducteurs 12.

Tel qu'illustré, les saillies 20 de retardement thermique présentent chacune une forme de cylindre. En variante, on pourrait prévoir toute autre forme pour lesdites saillies 20 de retardement thermique par exemple semi-sphérique, cylindrique creux, parallélépipédique ou sous forme d'un feuillard métallique.

Les saillies 20 de retardement thermique sont réalisées en matériau métallique, par exemple en cuivre.

Tel qu'illustré, chaque semi-conducteur 12 comprend trois joints secondaires 17 d'interconnexion et trois saillies 20 de retardement thermique, chacune solidaire d'un joint secondaire 17 d'interconnexion.

En variante, on pourrait prévoir que chaque semi-conducteur 12 comprenne au moins un joint secondaire 17 d'interconnexion et au moins une saillie 20 de retardement thermique, chacune solidaire d'un joint secondaire 17 d'interconnexion.

On pourrait également prévoir que plusieurs saillies 20 de retardement thermique soient assemblées sur un seul joint secondaire 17 d'interconnexion.

Les saillies 20 de retardement thermique sont ici réparties sur la surface supérieure 12b métallisée de chaque semi-conducteur 12 autour de la source 12d.

La figure 3 illustre les étapes d'un procédé 100 de fabrication du module 10 électronique de puissance des figures 1 et 2.

Le procédé 100 de fabrication du module 10 électronique de puissance comprend une première étape 101, visible sur la figure 4, de préparation du substrat et des connectiques 14, une deuxième étape 102, visible sur la figure 5, de dépose d'un joint principal d'interconnexion 13 ou brasure sur le substrat 11 pour l'assemblage, à l'étape 103, des semi-conducteur 12.

Lors de l'étape 103, visible sur la figure 6, les semi-conducteurs 12 sont assemblés au substrat 11 par des techniques de brasage ou frittage.

Le procédé 100 comprend en outre une étape 104, visible sur la figure 7, de raccordement électrique des semi-conducteurs 12, et notamment de la source 12d, par les fils de câblage 15, par exemple par une technique de procédé de soudage qui permet de faire une liaison filaire, ou « wire bonding » en termes anglo-saxons, assurant une connexion électrique entre la source du semi-conducteur 12 et le substrat 11.

Les étapes 101, 102, 103 et 104 sont connues et ne seront pas davantage décrites.

Tel qu'illustré, le procédé 100 comprend en outre une étape 105 de dépose d'un ou plusieurs joints secondaires d'interconnexion 17 ou brasures secondaires sur la surface supérieure 12b métallisée de chaque semi-conducteur 12, tel que visible à la figure 8.

Les joints secondaires d'interconnexion 17 permettent l'assemblage, à l'étape 106, de saillies 20 de retardement thermique sur les semi-conducteurs 12, tel que visible sur la figure 2. Cet assemblage peut se faire par technique de frittage ou par refusion du joint d'interconnexion 17.

Il est également envisageable que l'étape 105 consiste à déposer une pâte métallique, par exemple par une technique connue sous le nom de « dispensing » en termes anglo-saxon, sur la surface supérieure 12b métallisée du semi-conducteur 12, après câblage des connections électriques ou fils de câblage 15. La mise en oeuvre d'une refusion rapide pourra s'avérer nécessaire pour garantir le meilleur contact thermique avec la métallisation de surface de la puce semi-conducteur.

De manière nullement limitative, le procédé 100 pourrait également prévoir des étapes ultérieures (non représentées), d'assemblage du capot 16, d'injection d'un encapsulant, etc...

La ou les saillie(s) de retardement thermique 20 permettent d'établir un contact thermique performant avec la surface supérieure 12b métallisée du semi-conducteur 12 correspondant jouant le rôle de retardateur thermique. L'assemblage du semi-conducteur 12 avec la ou les saillie(s) de retardement thermique permet de forcer le passage du semi-conducteur 12 de l'état de court-circuit à l'état de circuit ouvert, assurant l'obtention d'un dégradation « propre » au sein du module électronique de puissance, c'est-à-dire n'endommageant pas d'autres composants du module électronique de puissance.

## Revendications

1. Module (10) électronique de puissance comprenant un substrat (11) comprenant au moins un circuit de puissance (11c), ledit module (10) comprenant au moins un joint principal d'interconnexion (13) solidaire du circuit de puissance (11c) et au moins un semi-conducteur (12) s'étendant selon un plan d'extension, et comprenant une surface supérieure (12b) métallisée et une surface inférieure (12a) assemblée au circuit de puissance (11c) par l'intermédiaire du joint principal d'interconnexion (13), **caractérisé en ce qu'**il comprend au moins un joint secondaire d'interconnexion (17) solidaire de la surface supérieure (12b) métallisée du semi-conducteur (12) et au moins une saillie (20) dotée d'une capacité de retardement thermique et solidaire de ladite surface supérieure (12b) métallisée par l'intermédiaire du joint secondaire (17) d'interconnexion, l'extrémité de la saillie (20) non solidaire de ladite surface supérieure (12b) métallisée étant toujours laissée libre.

2. Module (10) électronique de puissance selon la revendication 1, dans lequel la saillie (20) de retardement thermique présente une forme de cylindre ou d'un feuillard métallique.

3. Module (10) électronique de puissance selon l'une quelconque des revendications précédentes, dans lequel la saillie (20) de retardement thermique est réalisée en matériau conducteur, de préférence métallique.

4. Module (10) électronique de puissance selon l'une quelconque des revendications précédentes, comprenant une pluralité de saillies (20) de retardement thermique réparties sur la surface supérieure (12b) métallisée du semi-conducteur (12).

5. Module (10) électronique de puissance selon l'une quelconque des revendications précédentes, dans lequel le semi-conducteur (12) comprend un drain disposé sur la face inférieure (12a) et une grille (12c) et une source (12d) disposées sur la face supérieure (12b) métallisée, le semi-conducteur (12) comprenant en outre une métallisation du drain, de la grille et de la source.

6. Module (10) électronique de puissance selon les revendications 4 et 5, dans lequel les saillies (20) de retardement thermique sont réparties autour de la source (12d) du semi-conducteur (12).

7. Module (10) électronique de puissance selon l'une quelconque des revendications précédentes, dans lequel le joint principal (13) d'interconnexion est sous la forme d'une pâte et le joint secondaire (17) d'interconnexion est sous la forme d'une pâte, la pâte formant le joint principal (13) d'interconnexion présente un liquidus supérieur au liquidus de la pâte formant joint secondaire (17) d'interconnexion.

8. Module (10) électronique de puissance selon l'une quelconque des revendications précédentes, comprenant en outre au moins une connectique (14) solidaire du circuit de puissance (11c) et au moins un fils de câblage (15) reliant électriquement la connectique (14) et le semi-conducteur (12).

9. Procédé (100) de fabrication d'un module (10) électronique de puissance comprenant un substrat (11) comprenant au moins un circuit de puissance (11c), dans lequel :
- on prépare le substrat (11) ;
- on dépose au moins un joint principal d'interconnexion (13) sur le circuit de puissance (11c) du substrat (11) ; et
- on assemble au moins un semi-conducteur (12) au circuit de puissance (11c) du substrat (11) par l'intermédiaire du joint principal d'interconnexion (13) ; **caractérisé en ce que** selon le procédé :
- on dépose au moins un joint secondaire d'interconnexion (17) sur une surface supérieure (12b) métallisée du semi-conducteur (12) ; et
- on assemble au moins une saillie (20) de retardement thermique sur ladite surface supérieure (12b) métallisée par l'intermédiaire du joint secondaire (17) d'interconnexion, l'extrémité de la saillie (20) non solidaire de ladite surface supérieure (12b) métallisée étant toujours laissée libre.
